# DEMANDE DE BREVET EUROPEEN

(11) **EP 4 766 134 A1**
(43) Date de publication de la demande: **24.06.2026**
(21) Numéro de dépôt: 25223642.7
(22) Date de dépôt: 16.12.2025
(51) Int. Cl.: H10W 20/00

(54) **PROCÉDÉ DE RÉALISATION D'INTERCONNEXIONS**

(30) Priorité: 20.12.2024 FR 2414885
(71) Demandeur: Commissariat à l'Energie Atomique et aux Energies Alternatives, 75015 Paris (FR)
(72) Inventeur: CHÊNE, Thibaut, 38054 GRENOBLE Cedex 09 (FR); NEMOUCHI, Fabrice, 38054 GRENOBLE Cedex 09 (FR); SEGAUD, Roselyne, 38054 GRENOBLE Cedex 09 (FR); CHEVOLLEAU, Thierry, 38054 GRENOBLE Cedex 09 (FR)
(74) Mandataire: Hautier IP

(57) **Abrégé**

L'invention concerne un procédé de fabrication d'un niveau d'interconnexion comprenant une ligne métallique (62) et un via métallique (61), comprenant :
• une formation, sur un substrat (S), d'une première couche diélectrique (21),
• une formation, sur la première couche diélectrique (21), d'une couche d'arrêt de gravure (30) structurée comprenant un premier motif de ligne (301) et une ouverture de via (30v),
• une formation, sur la couche d'arrêt de gravure, d'une deuxième couche diélectrique (22),
• une formation, sur la deuxième couche diélectrique (22), d'un deuxième masque (40) définissant un deuxième motif de ligne (401) à l'aplomb du premier motif de ligne (301),
• une gravure des deuxième et première couches diélectriques (22, 21), configurée pour former respectivement des cavités supérieure et inférieure (50sup, 50inf),
• un remplissage des cavités inférieure et supérieure (50inf, 50sup) pour former la ligne métallique (62) et le via métallique (61).

## Description

### DOMAINE TECHNIQUE

La présente invention concerne le domaine technique des interconnexions pour la microélectronique. Elle trouve pour application particulièrement avantageuse la formation de vias et de lignes d'interconnexion.

### ETAT DE LA TECHNIQUE

Les interconnexions, qui sont typiquement formées par des procédés dits « de fin de ligne » ou « BEOL » (acronyme de « Back End of Line »), comprennent différents niveaux de lignes métalliques et de vias métalliques généralement à base de cuivre, dans une matrice diélectrique.

Une solution largement adoptée pour former les différents niveaux de lignes et de vias métalliques est connue sous la dénomination « double damascène ». Cette solution consiste à former d'abord les différents masques de gravure définissant les motifs de lignes et de vias, les uns sur les autres, sur une couche diélectrique épaisse. Cela permet ensuite de former dans la couche diélectrique les cavités destinées à recevoir les lignes et les vias, en une seule séquence d'étapes de gravure. Le remplissage des cavités par un métal, typiquement le cuivre, se fait également en une seule séquence de dépôts. Ce procédé est particulièrement efficace pour la réalisation de lignes et de vias métalliques interconnectés.

Cependant, des défauts peuvent apparaître dans les lignes et les vias métalliques. Ces défauts sont notamment dus à des résidus de gravure se formant dans les cavités avant le remplissage du métal. L'une des causes de formation de ces résidus est liée à la présence d'un masque de gravure à base de TiN. Les résidus de gravure induisent une diminution du rendement de réalisation de lignes et de vias fonctionnels.

Un objet de la présente invention est de proposer un procédé de formation de lignes et de vias d'interconnexion palliant au moins en partie les inconvénients mentionnés ci-dessus.

En particulier, un objet de la présente invention est de proposer un procédé alternatif de formation de lignes et de vias d'interconnexion. Un autre objet de la présente invention est de proposer un procédé de formation de lignes et de vias d'interconnexion qui limite ou supprime les résidus de gravure. Un autre objet de la présente invention est de proposer un procédé de formation de lignes et de vias d'interconnexion qui présente un nombre d'étapes limité.

### RESUME

Pour atteindre cet objectif, selon un mode de réalisation on prévoit un procédé de fabrication d'un niveau d'interconnexion comprenant au moins une ligne métallique et au moins un via métallique, ledit procédé comprenant :
- une fourniture d'un substrat comprenant au moins un plot de connexion,
- une formation, sur le substrat, d'une première couche diélectrique,
- une formation, sur la première couche diélectrique, d'une couche d'arrêt de gravure présentant une sélectivité S_{21:30} à la gravure vis-à-vis de la première couche diélectrique,
- une structuration de la couche d'arrêt de gravure, par l'intermédiaire d'au moins un premier masque, de façon à ce que la couche d'arrêt de gravure présente au moins un premier motif de ligne), ledit au moins un premier motif de ligne comprenant au moins une ouverture de via,
- une formation, sur la couche d'arrêt de gravure comprenant l'au moins une ouverture de via, d'une deuxième couche diélectrique,
- une formation, sur la deuxième couche diélectrique, d'un deuxième masque définissant au moins un deuxième motif de ligne à l'aplomb de l'au moins un premier motif de ligne,
- une gravure de la deuxième couche diélectrique, ladite gravure étant configurée pour former une cavité supérieure en s'arrêtant en partie sur la couche d'arrêt de gravure et,
- une gravure de la première couche diélectrique au travers de l'au moins une ouverture de via, ladite gravure étant configurée pour former une cavité inférieure en s'arrêtant sur l'au moins un plot de connexion du substrat,
- un remplissage des cavités inférieure et supérieure par au moins un matériau métallique de sorte à former l'au moins une ligne métallique dans la cavité supérieure et l'au moins un via métallique dans la cavité inférieure, ladite au moins une ligne métallique étant connectée audit au moins un via métallique au travers de l'au moins une ouverture de via, et ledit au moins un via métallique étant connecté audit au moins un plot de connexion du substrat.

Ce procédé recourt à une couche d'arrêt de gravure structurée et enterrée entre les première et deuxième couches diélectriques. Cette couche d'arrêt de gravure intercalaire permet avantageusement d'effectuer la ou les gravures des couches diélectriques successivement, par exemple en une seule étape ou de façon enchaînée, comme c'est le cas pour le procédé double damascène. Le nombre d'étapes du procédé est ainsi limité. Contrairement au procédé double damascène, la couche d'arrêt de gravure permet ici de contrôler précisément la profondeur de gravure de la cavité supérieure, destinée à former l'au moins une ligne métallique. La reproductibilité du procédé est améliorée. Les cavités définies par les motifs de ligne et de via sont également avantageusement remplies en une seule étape. Le nombre d'étapes du procédé est ainsi limité.

Contrairement au procédé double damascène connu, le procédé selon l'invention dissocie la formation des premier et deuxième masques de gravure. Les premier et deuxième masques de gravure ne sont ici pas directement superposés. Il n'est donc pas nécessaire de recourir à un masque de gravure appelé masque dur, typiquement à base de TiN, contrairement au procédé double damascène. La couche d'arrêt de gravure peut faire office de masque dur intégré dans l'empilement des couches diélectriques. Selon une possibilité avantageuse, le deuxième masque est uniquement à base de matériaux organiques. Le premier masque peut être par exemple à base de l'un parmi SiCN, HfO2, SiC, SiON. Cela évite la formation de résidus de gravure dans les cavités. Les défauts de remplissage sont ainsi significativement diminués. Le rendement du procédé de fabrication des niveaux d'interconnexion est amélioré.

L'invention prévoit également selon un deuxième aspect un dispositif typiquement issu de ce procédé de fabrication. Ce dispositif comprend, en empilement suivant une direction z :
- un substrat comprenant au moins un plot de connexion,
- un niveau d'interconnexion comprenant :
   - au moins un via métallique au sein d'une première couche diélectrique, ledit au moins un via métallique étant connecté audit au moins un plot de connexion,
   - au moins une ligne métallique au sein d'une deuxième couche diélectrique, ladite au moins une ligne métallique étant connectée audit au moins un via métallique,

Avantageusement, le dispositif comprend, intercalée entre l'au moins un via et l'au moins une ligne, une couche d'arrêt de gravure présentant une sélectivité à la gravure S_{21:30} vis-à-vis de la première couche diélectrique, ladite couche d'arrêt de gravure comprenant au moins une ouverture de via de sorte que l'au moins un via et l'au moins une ligne sont connectés au travers de ladite au moins une ouverture de via.

Les avantages décrits ci-dessus en regard du procédé s'appliquent *mutatis mutandis* au dispositif selon l'invention.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1 à 10 illustrent dans un plan xz, des coupes transversales représentant différentes étapes du procédé de fabrication d'un niveau d'interconnexion selon un mode de réalisation de la présente invention.
La figure 11 illustre schématiquement en vue de dessus une étape du procédé de fabrication selon un mode de réalisation de la présente invention.
Les figures 12 à 16 illustrent schématiquement dans un plan xz, des coupes transversales représentant différentes étapes du procédé de fabrication d'un niveau d'interconnexion selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et/ou les dimensions des différentes couches et motifs ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la couche d'arrêt de gravure présente une sélectivité S_{21:30} à la gravure vis-à-vis de la première couche diélectrique supérieure ou égale à 5:1.

Selon un exemple, la structuration de la couche d'arrêt de gravure comprend les sous-étapes suivantes :
- une formation du premier masque sur la couche d'arrêt de gravure, ledit premier masque définissant de façon directe l'au moins un premier motif de ligne comprenant l'au moins une ouverture de via,
- un retrait partiel de la couche d'arrêt de gravure, uniquement au niveau de zones de la couche d'arrêt de gravure non couvertes par le premier masque, de façon à exposer la première couche diélectrique en dehors des zones couvertes par le premier masque,
- un retrait du premier masque.

Dans cet exemple, les parties couvertes par le premier masque correspondent au premier motif de ligne.

Selon un exemple, la formation du premier masque se fait par double lithographie. Ce procédé connu de lithographie permet d'optimiser, voire de dépasser les limitations en résolution d'un équipement d'insolation classique de lithographie. Une autre solution consiste à utiliser un équipement de lithographie mieux résolu, par exemple en extrême UV ou en lithographie électronique. La formation du premier masque peut comprendre une première lithographie suivie d'une deuxième lithographie, puis une gravure. Alternativement, la formation du premier masque peut comprendre une première lithographie suivie d'une première gravure, puis une deuxième lithographie suivie d'une deuxième gravure.

Selon un exemple, le premier masque est à base d'un matériau non métallique, par exemple à base de SiON, SiN, SiCN, HfO2, SiON, SiC, SiO2.

Selon un exemple, l'au moins un deuxième motif de ligne présente une dimension critique CD₂, prise selon un axe x, inférieure à une dimension CD₁ de l'au moins premier motif de ligne prise selon l'axe x. Cela permet de minimiser le risque lié à un désalignement entre les premier et deuxième motifs. Le premier motif de ligne étant typiquement plus large que le deuxième motif de ligne, la gravure de la deuxième couche diélectrique, associée au deuxième motif de ligne, s'arrêtera effectivement sur la couche d'arrêt de gravure, structurée selon le premier motif de ligne. La fiabilité du procédé est augmentée.

Selon un exemple, la gravure de la deuxième couche diélectrique et la gravure de la première couche diélectrique sont réalisées par une seule et même gravure, lors d'une seule et même étape.

Selon un exemple, les première et deuxième couches diélectriques sont à base d'un même matériau diélectrique.

Selon un exemple, les première et deuxième couches diélectriques sont respectivement à base d'un premier matériau diélectrique et d'un deuxième matériau diélectrique, lesdits premier et deuxième matériaux diélectriques étant différents entre eux.

Selon un exemple, la gravure de la deuxième couche diélectrique et la gravure de la première couche diélectrique sont réalisées par deux gravures successives différentes.

Selon un exemple, la couche d'arrêt de gravure est à base d'un matériau pris parmi : SiC, HfO2, SiN, SiCN, SiON.

Selon un exemple, le deuxième masque est uniquement à base de matériaux organiques. En particulier, ce deuxième masque n'est pas à base de matériaux métalliques tels que TiN. Cela permet d'éviter la formation de résidus lors de la gravure ou après la gravure.

Selon l'invention, la couche d'arrêt de gravure présente au moins un premier motif de ligne et l'au moins une ligne métallique est disposée, selon la direction z, sur ledit au moins un premier motif de ligne. Lorsque la couche d'arrêt de gravure est continue comme dans l'art antérieur, la constante diélectrique augmente dans les couches environnantes ; cela peut engendrer une diaphonie (« crosstalk » en anglais) entre les interconnexions de ces couches environnantes, notamment lorsque les interconnexions sont très denses.

La structuration de la couche d'arrêt de gravure sous forme de motif de ligne permet au contraire de maintenir une constante diélectrique faible. Cela évite l'apparition du phénomène de crosstalk. Des interconnexions relativement plus denses peuvent ainsi être réalisées.

Selon un exemple, l'au moins une ligne présente une dimension critique CD_{ligne}, prise selon un axe x, inférieure à une dimension CD₁, prise selon l'axe x, de l'au moins un premier motif de ligne de la couche d'arrêt de gravure. La ligne ne déborde pas, latéralement, de la couche d'arrêt de gravure structurée.

Selon un exemple, l'au moins un via présente une dimension critique CDᵥᵢₐ, prise selon un axe x, sensiblement égale à une dimension CDₒₚₑₙ de l'au moins une ouverture de via prise selon l'axe x.

Selon un exemple, l'au moins une ouverture de via présente une dimension CDₒₚₑₙ, prise selon un axe x, inférieure à une dimension CD₁, prise selon l'axe x, de l'au moins un premier motif de ligne de la couche d'arrêt de gravure.

Selon un exemple, la couche d'arrêt de gravure est à base d'un matériau pris parmi : SiC, HfO2, SiN, SiCN, SiON, et la première couche diélectrique est à base d'un matériau diélectrique pris parmi : SiOCH, SiCH, SiO₂ (par exemple formé à partir d'un précurseur silane ou d'un précurseur d'orthosilicate de tétraéthyle TEOS), SiOCH. Cela permet d'obtenir une sélectivité S_{21:30} à la gravure entre la première couche diélectrique et la couche d'arrêt de gravure supérieure ou égale à 5:1. La vitesse de gravure de la couche d'arrêt de gravure est au moins cinq fois inférieure à la vitesse de gravure de la première couche diélectrique. Selon un exemple, la sélectivité S_{21:30} à la gravure entre la première couche diélectrique et la couche d'arrêt de gravure est supérieure à 10:1.

Selon un exemple, les première et deuxième couches diélectriques sont à base du même matériau diélectrique. Selon un autre exemple, les première et deuxième couches diélectriques sont respectivement à base d'un premier matériau diélectrique et d'un deuxième matériau diélectrique, lesdits premier et deuxième matériaux diélectriques étant différents entre eux. Les premier et deuxième matériaux diélectriques peuvent par exemple avantageusement présenter deux constantes diélectriques distinctes.

Selon un exemple, l'au moins un via et l'au moins une ligne sont à base d'un même matériau métallique, par exemple du cuivre.

Selon un exemple alternatif, l'au moins un via est à base d'un premier métal et l'au moins une ligne est à base d'un deuxième métal différent du premier métal.

Selon un exemple, le substrat est à base de Si ou SiC et comprend au moins un composant connecté à l'au moins un plot de connexion. Ce ou ces composants correspondent par exemple aux composants d'un niveau FEOL (acronyme de « Front End of Line »).

Sauf incompatibilité, il est entendu que l'ensemble des caractéristiques optionnelles ci-dessus et/ou les variantes indiquées peuvent être combinées de façon à former un mode de réalisation qui n'est pas nécessairement illustré ou décrit. Un tel mode de réalisation n'est évidemment pas exclu de l'invention.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, une couche d'arrêt de gravure à base de nitrure de silicium SiN peut par exemple comprendre du nitrure de silicium non stœchiométrique (SiN), ou du nitrure de silicium stœchiométrique (Si₃N₄), ou encore un oxy-nitrure de silicium (SiON).

Le mot « diélectrique » qualifie un matériau dont la conductivité électrique est suffisamment faible dans l'application donnée pour servir d'isolant. Dans la présente invention, les première et deuxième couches diélectriques présentent de préférence une constante diélectrique inférieure à 5. Les première et deuxième couches diélectriques sont dites « low k » (à basse constante diélectrique).

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé. Les gravures des première et deuxième couches diélectriques peuvent notamment être enchaînées ou être considérées comme faisant partie d'une seule et même étape de gravure.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche diélectrique présente typiquement une épaisseur selon z. Un via formé au sein d'une telle couche diélectrique présente une hauteur selon z. Les termes relatifs « sur », « surmonte », « supérieur », « sous », « sous-jacent » « inférieur » se réfèrent à des positions prises selon la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

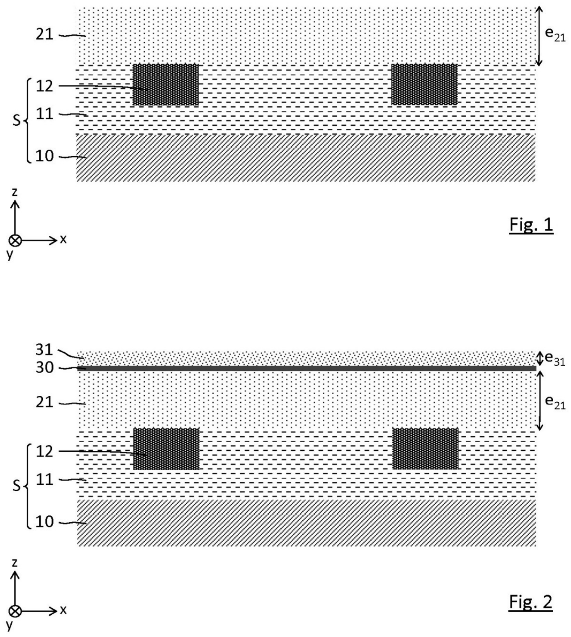

Les étapes de fabrication d'un niveau d'interconnexion selon l'invention sont illustrées aux figures 1 à 15.

Comme illustré à la figure 1, le procédé comprend une fourniture d'un substrat S comprenant typiquement une couche de support 10 à base de silicium portant des composants, par exemple des transistors. Le substrat S comprend typiquement des plots de connexion 12 intégrés dans une première couche **11** à base d'oxyde de silicium, surmontant la couche de support 10. Un objectif du procédé selon l'invention est de former des vias connectant les plots 12, et des lignes surmontant et connectant ces vias.

Une première couche diélectrique 21, typiquement à base d'un premier oxyde « low k », est d'abord formée sur le substrat S. Cette couche diélectrique 21 présente typiquement une épaisseur e₂₁ de l'ordre de quelques dizaines de nanomètres, par exemple de l'ordre de 40 nm. Après dépôt, la première couche diélectrique 21 est typiquement planarisée.

Comme illustré à la figure 2, une couche d'arrêt de gravure 30 est ensuite directement formée sur la première couche diélectrique 21. Cette couche d'arrêt de gravure 30 présente typiquement une épaisseur de l'ordre de quelques nanomètres, par exemple inférieure à 5 nm. Elle est de préférence à base d'un nitrure de silicium, par exemple SiN ou SiCN. La formation de la couche d'arrêt de gravure 30 peut notamment être effectuée par l'une des techniques suivantes: dépôt physique en phase vapeur (PVD, acronyme de « physical vapor deposition »), dépôt chimique en phase vapeur (CVD, acronyme de « chemical vapor deposition »), dépôt chimique en phase vapeur assisté par plasma (PECVD, acronyme de « plasma enhanced chemical vapor deposition »), dépôt par couche atomique (ALD, acronyme de « atomic layer deposition »), dépôt par couche atomique assisté par plasma (PEALD, acronyme de « plasma enhanced atomic layer deposition »).

Une couche 31 dite de texturation, destinée à former un premier masque de gravure, est déposée sur la couche d'arrêt de gravure 30. Cette couche de texturation 31 est par exemple à base de SiON. Elle présente typiquement une épaisseur e₃₁ de l'ordre de quelques nanomètres à quelques dizaines de nanomètres, par exemple de l'ordre de 5 nm à 10 nm. La couche de texturation 31 est ensuite structurée par lithographie/gravure de façon à former le premier masque de gravure. Cette structuration peut se faire par lithographie simple, par exemple en insolation extrême UV, ou par double lithographie connue sous l'appellation « double patterning ».

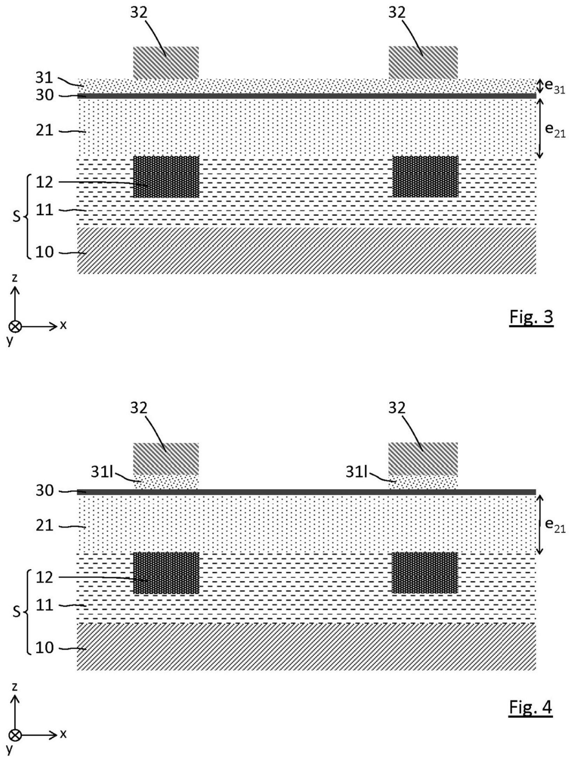

Les figures 3 à 8 illustrent une structuration de la couche de texturation 31 par « double patterning ».

Comme illustré à la figure 3, une première lithographie peut être effectuée de façon à définir des motifs de ligne 32 dans une première couche de résine photosensible, à l'aplomb des plots 12.

Comme illustré à la figure 4, une première gravure peut ensuite être effectuée de façon à transférer les motifs de ligne 32 dans la couche de texturation 31. La couche de texturation est ainsi partiellement structurée. Cette première structuration partielle permet d'obtenir des motifs de ligne 31l dans la couche de texturation.

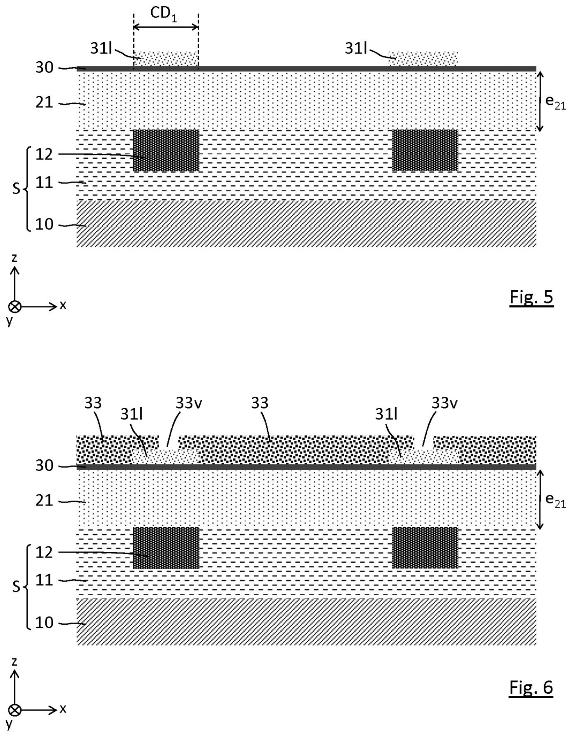

Comme illustré à la figure 5, les motifs de ligne 32 de la première couche de résine sont ensuite retirés, par exemple par plasma à base d'oxygène, de façon à réexposer les motifs de ligne 31l de la couche de texturation partiellement structurée. Dans le cas de la structuration par « double patterning », les motifs de ligne 31l présentent typiquement une dimension CD₁, selon x, comprise entre 70 nm et 100 nm, par exemple de l'ordre de 80 nm.

Comme illustré à la figure 6, une deuxième lithographie peut être effectuée de façon à définir des motifs d'ouverture de via 33v dans une deuxième couche 33 de résine photosensible, sur les motifs de ligne 31l de la couche de texturation partiellement structurée. Les motifs d'ouverture de via 33v sont alignés à l'aplomb des plots 12.

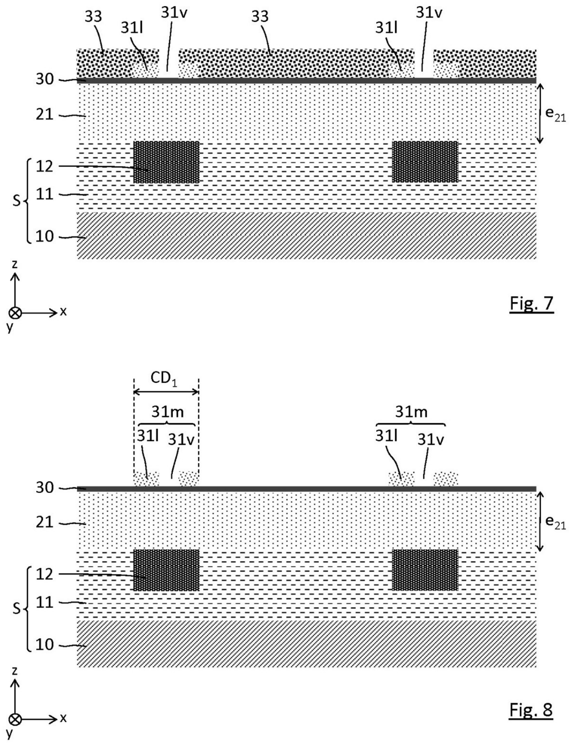

Comme illustré à la figure 7, une deuxième gravure peut être effectuée de façon à compléter la structuration de la couche de texturation. Les motifs d'ouverture de via 33v sont transférés dans la couche de texturation. Cette deuxième structuration permet d'obtenir des motifs d'ouverture de via 31v au sein des motifs de ligne 31l de la couche de texturation.

Comme illustré à la figure 8, après retrait de la deuxième couche 33 de résine, un premier masque de gravure 31m comprenant des motifs de ligne 31l et des motifs d'ouverture de via 31v est formé sur la couche d'arrêt de gravure 30.

Le premier masque de gravure n'est pas nécessairement à base d'une couche de texturation, ni nécessairement réalisé par « double patterning ». Lorsque le premier masque de gravure est réalisé par lithographie simple, la dimension CD₁ des motifs de ligne 31l est typiquement comprise entre 100 nm et 200 nm, par exemple de l'ordre de 130 nm. Lorsque le premier masque de gravure est réalisé par lithographie extrême UV, la dimension CD₁ des motifs de ligne 31l est typiquement comprise entre 20 nm et 50 nm, par exemple de l'ordre de 26 nm. Ce premier masque de gravure 31m est ici utilisé pour transférer directement les motifs de ligne 31l et les motifs d'ouverture de via 31v dans la couche d'arrêt de gravure 30.

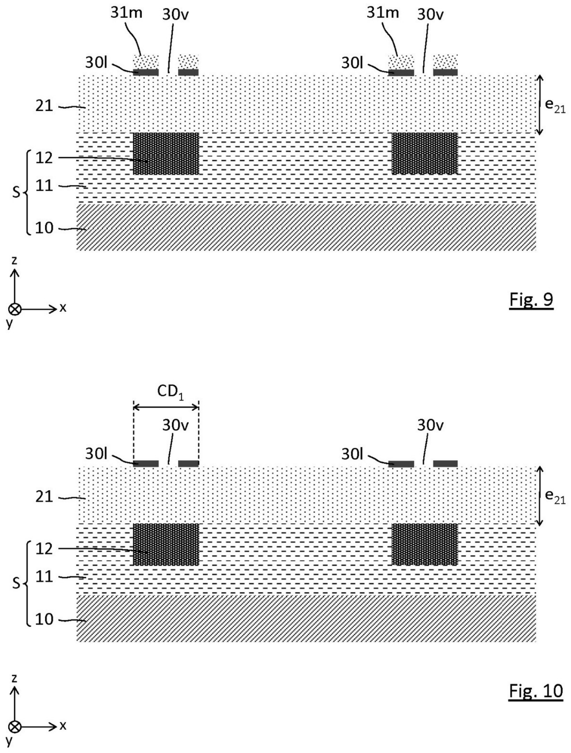

Comme illustré à la figure 9, une gravure anisotrope de la couche d'arrêt de gravure 30, selon z, est effectuée de façon à former les motifs de ligne 30l sous les motifs de ligne 31l, et les motifs d'ouverture de via 30v sous les motifs d'ouverture de via 31v. Cette gravure peut présenter une chimie de gravure halogénée à base de chlore ou de fluor, selon le type de masque 31m et la nature de la couche d'arrêt de gravure 30. Pour une couche d'arrêt de gravure 30 à base d'hafnium, la gravure peut se faire à partir d'une chimie de gravure chlorée, par exemple BCl, BCl₃. Pour une couche d'arrêt de gravure 30 à base de silicium, la gravure peut se faire à partir d'une chimie de gravure fluorocarbonnée, par exemple CHF₃, CF₄.

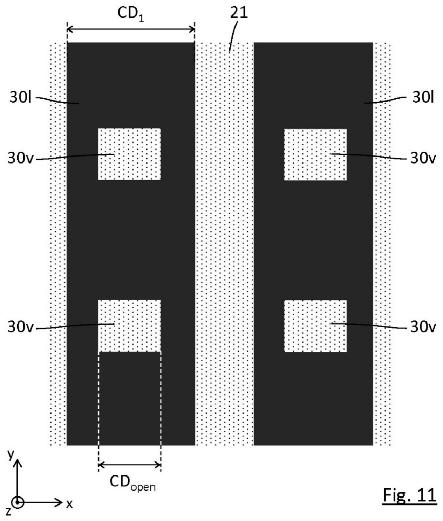

Comme illustré aux figures 10 et 11, en vue transverse et en vue de dessus respectivement, après retrait du premier masque de gravure 31m, une couche d'arrêt de gravure structurée, comprenant des motifs de ligne 30l et des motifs d'ouverture de via 30v, est obtenue sur la première couche diélectrique 21. Les motifs de ligne 30l présentent typiquement la dimension CD₁ selon x, et les motifs d'ouverture de via 30v présentent typiquement la dimension CDₒₚₑₙ selon x. Lorsque le premier masque de gravure est réalisé par lithographie simple ou par « double patterning », la dimension CDₒₚₑₙ des motifs d'ouverture de via 30v est typiquement comprise entre 30 nm et 70 nm, par exemple de l'ordre de 50 nm. Lorsque le premier masque de gravure est réalisé par lithographie extrême UV, la dimension CDₒₚₑₙ des motifs d'ouverture de via 30v peut être comprise entre 8 nm et 20 nm, par exemple de l'ordre de 10 nm.

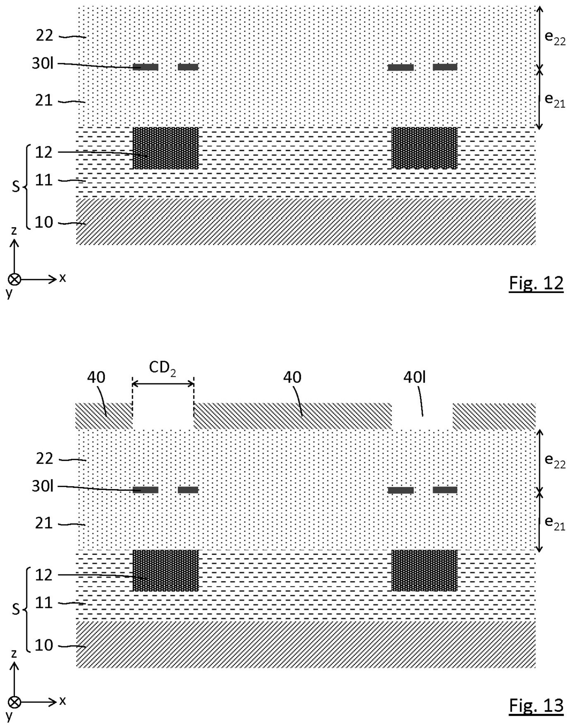

Comme illustré à la figure 12, après structuration de la couche d'arrêt de gravure, une deuxième couche diélectrique 22, typiquement à base d'un deuxième oxyde « low k », est ensuite formée sur la première couche diélectrique 21 et sur la couche d'arrêt de gravure structurée 30l. Cette couche diélectrique 22 présente typiquement une épaisseur e₂₂ de l'ordre de quelques dizaines de nanomètres, par exemple de l'ordre de 40 nm. Les épaisseurs e₂₁ et e₂₂ sont de préférence choisies de façon à ce que l'épaisseur totale e₂₁ + e₂₂ des couches diélectriques 21, 22 soit comprise entre 90 nm et 110 nm. Le deuxième oxyde « low k » peut être identique au premier oxyde « low k ». Alternativement, les premier et deuxième oxydes « low k » peuvent être de nature différente. Après dépôt, la deuxième couche diélectrique 22 est typiquement planarisée.

Comme illustré à la figure 13, un deuxième masque de gravure 40 comprenant des motifs de ligne 40l est formé sur la deuxième couche diélectrique 22. Ce deuxième masque de gravure 40 est de préférence à base de couches organiques, par exemple sous forme d'un empilement connu sous la dénomination « trilayer », comprenant typiquement une couche de planarisation organique, une couche antireflets et une couche de résine photosensible.

Les motifs de ligne 40l de ce deuxième masque de gravure 40 sont alignés avec les motifs de ligne 30l de la couche d'arrêt de gravure, de façon à ce que les motifs de ligne 40l soient à l'aplomb des motifs de ligne 30l. Les motifs de ligne 40l présentent typiquement une dimension CD₂ selon x légèrement inférieure, par exemple 10% inférieure, à la dimension CD₁ selon x des motifs de ligne 30l. Cela facilite l'alignement des motifs 40l, 30l entre eux. Une certaine tolérance sur la précision d'alignement est ainsi obtenue.

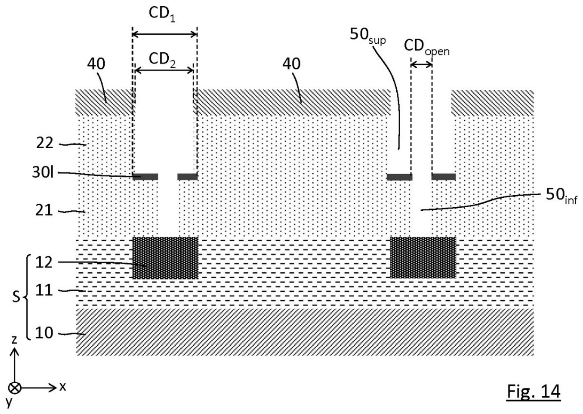

Comme illustré à la figure 14, les première et deuxième couches diélectriques 21, 22 sont ensuite gravées sur toute leur épaisseur, selon z, au travers des motifs de ligne 40l. La deuxième couche diélectrique 22 est d'abord gravée pour former les cavités supérieures 50ₛᵤₚ, puis la première couche diélectrique 21 est gravée pour former les cavités inférieures 50_{inf}. Les gravures des première et deuxième couches diélectriques 21, 22 sont de préférence enchaînées. Selon une possibilité, notamment lorsque les première et deuxième couches diélectriques 21, 22 sont de nature identique, les gravures de ces couches diélectriques 21, 22 sont effectuées en une seule et même étape, avec la même chimie de gravure.

Les gravures sont ici choisies de façon à graver sélectivement les premier et deuxième oxydes « low k » des première et deuxième couches diélectriques 21, 22 vis-à-vis du matériau de la couche d'arrêt de gravure. En particulier, la sélectivité de gravure S_{21:30}, c'est-à-dire le rapport entre la vitesse de gravure du premier oxyde « low k » sur la vitesse de gravure du matériau de la couche d'arrêt de gravure, est supérieure ou égale à 5:1, de préférence supérieure ou égale à 10:1. Les gravures peuvent être à base d'une chimie de type CF₄/H₂.

Après gravure, des cavités supérieures 50ₛᵤₚ présentant la dimension CD₂ selon x sont obtenues au-dessus de la couche d'arrêt de gravure structurée 30l présentant la dimension CD₁ selon x. Des cavités inférieures 50_{inf} présentant la dimension CDₒₚₑₙ selon x sont obtenues en-dessous de la couche d'arrêt de gravure structurée 30l.

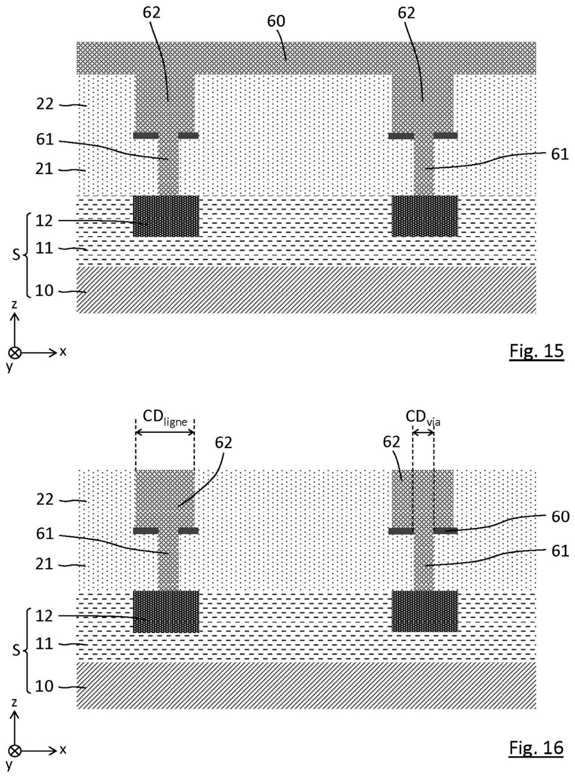

Comme illustré à la figure 15, les cavités inférieures 50_{inf} et les cavités supérieures 50ₛᵤₚ sont ensuite remplies par dépôt d'une couche métallique 60, typiquement à base de cuivre. Ce dépôt peut typiquement se faire par électrodéposition. Les vias métalliques 61 et les lignes métalliques 62 sont ainsi formés. Un dépôt d'une couche barrière à la diffusion, par exemple à base de TaN/Ta, peut être prévu avant remplissage des cavités 50_{inf}, 50ₛᵤₚ, de façon connue (non illustré).

Comme illustré à la figure 16, une étape classique de planarisation par polissage mécano-chimique (CMP) est effectuée pour finaliser la formation du niveau d'interconnexions comprenant les vias métalliques 61 et les lignes métalliques 62. Les lignes métalliques 62 présentent une dimension critique CD_{ligne} selon x, égale à la dimension CD₂ des cavités supérieures 50ₛᵤₚ. Les vias métalliques 61 présentent une dimension critique CDᵥᵢₐ selon x, égale à la dimension CDₒₚₑₙ des cavités inférieures 50_{inf}.

L'invention n'est pas limitée aux modes de réalisations précédemment décrits. En particulier, il est envisageable de structurer la couche d'arrêt de gravure de façon indirecte, en formant un premier masque de gravure de polarité inverse puis en effectuant un dépôt localisé du matériau de la couche d'arrêt de gravure.

## Revendications

1. Procédé de fabrication d'un niveau d'interconnexion comprenant au moins une ligne métallique (62) et au moins un via métallique (61), ledit procédé comprenant :
• une fourniture d'un substrat (S) comprenant au moins un plot de connexion (12),
• une formation, sur le substrat (S), d'une première couche diélectrique (21),
• une formation, sur la première couche diélectrique (21), d'une couche d'arrêt de gravure (30) présentant une sélectivité S_{21:30} à la gravure vis-à-vis de la première couche diélectrique (21),
• une structuration de la couche d'arrêt de gravure (30), par l'intermédiaire d'au moins un premier masque (31m), de façon à ce que la couche d'arrêt de gravure (30) présente au moins un premier motif de ligne (30l), ledit au moins un premier motif de ligne (30l) comprenant au moins une ouverture de via (30v),
• une formation, sur la couche d'arrêt de gravure comprenant l'au moins une ouverture de via (30v), d'une deuxième couche diélectrique (22),
• une formation, sur la deuxième couche diélectrique (22), d'un deuxième masque (40) définissant au moins un deuxième motif de ligne (40l) à l'aplomb de l'au moins un premier motif de ligne (30l),
• une gravure de la deuxième couche diélectrique (22), ladite gravure étant configurée pour former une cavité supérieure (50ₛᵤₚ) en s'arrêtant en partie sur la couche d'arrêt de gravure (30, 30l) et,
• une gravure de la première couche diélectrique (21) au travers de l'au moins une ouverture de via (30v), ladite gravure étant configurée pour former une cavité inférieure (50_{inf}) en s'arrêtant sur l'au moins un plot de connexion (12) du substrat (S),
• un remplissage des cavités inférieure et supérieure (50_{inf}, 50ₛᵤₚ) par au moins un matériau métallique de sorte à former l'au moins une ligne métallique (62) dans la cavité supérieure (50ₛᵤₚ) et l'au moins un via métallique (61) dans la cavité inférieure (50_{inf}), ladite au moins une ligne métallique (62) étant connectée audit au moins un via métallique (61) au travers de l'au moins une ouverture de via (30v), et ledit au moins un via métallique (61) étant connecté audit au moins un plot de connexion (12) du substrat (S).

2. Procédé selon la revendication précédente, dans lequel la structuration de la couche d'arrêt de gravure (30) comprend les sous-étapes suivantes :
• une formation du premier masque (31m) sur la couche d'arrêt de gravure (30), ledit premier masque (31m) définissant de façon directe l'au moins un premier motif de ligne (30l) comprenant l'au moins une ouverture de via (30v),
• un retrait partiel de la couche d'arrêt de gravure (30), uniquement au niveau de zones de la couche d'arrêt de gravure (30) non couvertes par le premier masque (31m), de façon à exposer la première couche diélectrique (21) en dehors des zones couvertes par le premier masque (31m),
• un retrait du premier masque (31m).

3. Procédé selon la revendication précédente, dans lequel la formation du premier masque (31m) se fait par double lithographie.

4. Procédé selon l'une quelconque des revendications précédentes, dans lequel le premier masque (31m) est à base d'un matériau non métallique, par exemple à base de SiON, SiN, SiCN, HfO2, SiON, SiC, SiO2.

5. Procédé selon l'une quelconque des revendications précédentes, dans lequel l'au moins un deuxième motif de ligne (40l) présente une dimension critique CD₂, prise selon un axe x, inférieure à une dimension CD₁ de l'au moins premier motif de ligne (30l) prise selon l'axe x.

6. Procédé selon l'une quelconque des revendications précédentes, dans lequel la gravure de la deuxième couche diélectrique (22) et la gravure de la première couche diélectrique (21) sont réalisées par une seule et même gravure, lors d'une seule et même étape.

7. Procédé selon l'une quelconque des revendications précédentes, dans lequel les première et deuxième couches diélectriques (21, 22) sont à base d'un même matériau diélectrique.

8. Procédé selon l'une quelconque des revendications précédentes, dans lequel la couche d'arrêt de gravure (30) est à base d'un matériau pris parmi : SiC, HfO2, SiN, SiCN, SiON.

9. Procédé selon l'une quelconque des revendications précédentes, dans lequel le deuxième masque (40) est uniquement à base de matériaux organiques.

10. Dispositif comprenant en empilement suivant une direction z :
• un substrat (S) comprenant au moins un plot de connexion (12),
• un niveau d'interconnexion comprenant
∘ **au moins** un via métallique (61) au sein d'une première couche diélectrique (21), ledit au moins un via métallique (61) étant connecté audit au moins un plot de connexion (12),
∘ au moins une ligne métallique (62) au sein d'une deuxième couche diélectrique (22), ladite au moins une ligne métallique (62) étant connectée audit au moins un via métallique (61),
ledit dispositif étant **caractérisé en ce qu'**il comprend, intercalée entre l'au moins un via (61) et l'au moins une ligne (62), une couche d'arrêt de gravure (30, 30l) présentant une sélectivité à la gravure S_{21:30} vis-à-vis de la première couche diélectrique (21),
ladite couche d'arrêt de gravure (30) comprenant au moins une ouverture de via (30v) de sorte que l'au moins un via (61) et l'au moins une ligne (62) sont connectés au travers de ladite au moins une ouverture de via (30v),
ladite couche d'arrêt de gravure (30) présentant au moins un premier motif de ligne (30l), ledit dispositif étant **caractérisé en ce que** l'au moins une ligne métallique (62) est disposée, selon la direction z, sur ledit au moins un premier motif de ligne (30l).

11. Dispositif selon la revendication précédente, dans lequel l'au moins un via (61) présente une dimension critique CDᵥᵢₐ, prise selon un axe x, sensiblement égale à une dimension CDₒₚₑₙ de l'au moins une ouverture de via (30v) prise selon l'axe x.

12. Dispositif selon l'une quelconque des revendications 10 à **11,** dans lequel la couche d'arrêt de gravure (30) est à base d'un matériau pris parmi : SiC, HfO2, SiN, SiCN, SiON et la première couche diélectrique (21) est à base d'un matériau diélectrique pris parmi : SiOCH, SiCH, SiO₂, SiOCH.

13. Dispositif selon la revendication précédente, dans lequel les première et deuxième couches diélectriques (21, 22) sont à base du même matériau diélectrique.

14. Dispositif selon l'une quelconque des revendications 10 à 13, dans lequel l'au moins un via (61) et l'au moins une ligne (62) sont à base d'un même matériau métallique.
